(19) Europäisches Patentamt
European Patent Office
Office européen des brevets

(11) Publication number: 0 138 531 B1

(12) **EUROPEAN PATENT SPECIFICATION**

(45) Date of publication of patent specification: **27.01.88**

(51) Int. Cl.[4]: **C 23 G 1/10,** C 23 G 1/36, C 23 F 1/18, C 25 F 7/02

(21) Application number: **84306812.3**

(22) Date of filing: **05.10.84**

(54) **Process for cleaning copper base materials and regenerating the cleaning solution.**

(30) Priority: **06.10.83 US 539598**

(43) Date of publication of application:
**24.04.85 Bulletin 85/17**

(45) Publication of the grant of the patent:
**27.01.88 Bulletin 88/04**

(84) Designated Contracting States:
**DE FR GB IT**

(56) References cited:
**EP-A-0 082 210**
**US-A-3 470 044**
**US-A-3 671 344**

(73) Proprietor: **Olin Corporation**
**427 North Shamrock Street**
**East Alton Illinois 62024 (US)**

(72) Inventor: **Pryor, Michael J.**
**98 Maplevale Drive**
**Woodbridge Connecticut 06410 (US)**
Inventor: **Brock, Andrew J.**
**44 Royalwood Court**
**Cheshire Connecticut 06410 (US)**

(74) Representative: **Lambert, Hugh Richmond et al**
**D. YOUNG & CO. 10 Staple Inn**
**London, WC1V 7RD (GB)**

**EP 0 138 531 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a process for cleaning copper base alloys using an aqueous peroxydisulfuric acid solution and for regenerating the spent cleaning solution.

The fundamental cleaning medium used in the copper industry is sulfuric acid at a strength of about 10 to 15% by volume. The extensive use of sulfuric acid is based on the fact that for most brasses and high copper alloys, the annealing oxides are readily soluble in mineral acids. This produces very rapid oxide removal and the resulting cleaning process is, therefore, readily amenable to a short immersion time, continuous operation.

However, an increasing number of copper alloys now contain elements which form insoluble, refractory-type oxides. For these alloys, alternative cleaning procedures have been developed. These alternative cleaning procedures generally involve adding an oxidant such as sodium dichromate or hydrogen peroxide to the cleaning solution. While sodium dichromate has been used effectively for years, its use has been discontinued because of its known high toxicity and restrictions on waste treatment and discharge level. While hydrogen peroxide does not suffer from these disadvantages, it is limited by its inherent stability problems. Hydrogen peroxide will decompose to water plus oxygen during storage. In addition and more importantly, the decomposition of peroxide is greatly accelerated by elevated temperatures and/or the presence of dissolved copper in the cleaning solution. These factors limit the maximum etching rates that can be obtained with solutions containing hydrogen peroxide.

In response to these shortcomings and the need for an effective oxidising cleaning solution, attention has turned to persulfate solutions. The use of persulfate is attractive for a copper cleaning operation because the end products of the reaction of persulfate with copper are sulfuric acid and copper sulfate. As such, no special waste water treatment is required. Furthermore, the depleted or spent persulfate solution may be regenerated and the copper in the depleted solution reclaimed. Typically, the persulfate cleaning solutions comprise an aqueous solution containing a persulfate salt such as ammonium persulfate or sodium persulfate. Persulfate salts have been used because they are readily available. U.S. Patent Nos. 2,978,301 to Margulies et al., 3,475,242 to Radimer, 3,671,344 to Chiang et al., 3,887,405 to Fong et al. and 4,144,144 to Radimer et al. illustrate the use of aqueous persulfate salt solutions to etch copper materials.

The use of electrochemical cells to regenerate spent solutions and to reclaim metal values from the spent solutions are well known in the art. Typically, these cells have at least one anode chamber and at least one cathode chamber physically separated by a membrane. Depending upon the type of solution being regenerated and the chemical reactions sought to be produced, the membrane generally comprises either an ion exchange member or a microporous separator. The spent solution is used as either the anolyte or the catholyte. U.S. Patent Nos. 2,748,071 to Eisler, 2,865,823 to Harris et al., 3,761,369 to Tirrell, 3,764,503 to Lancy et al., 4,051,001 to Inoue et al., and 4,149,946 to Burke illustrate some of the electrochemical cells to regenerate the spent cleaning solutions.

It has been suggested in the prior art to regenerate persulfate etchants using electrochemical cells. In one such persulfate etchant regeneration technique, the spent etchant is treated to remove a substantially persulfate-free mixture containing ammonium persulfate and the corresponding metal sulfate. The substantially persulfate-free mixture is then transferred to the cathode chamber of an electrochemical cell where it is used as the catholyte. The remainder of the spent solution is transferred to the anode chamber of the cell where it is used as the anolyte. The cathode and anode chambers of the cell are separated by a diaphragm which permits at least hydrogen ions to pass freely between the anolyte and the catholyte while preventing any substantial amounts of persulfate in the anolyte from mixing with the catholyte. By passing an electric current between the anolyte and catholyte, metal is plated out of the cathode and persulfate values are produced at the anode. U.S. Patent No. 3,406,108 to Radimer et al. illustrates this technique for regenerating spent persulfate etchants. The primary deficiency of this technique is its complexity which renders it commercially unacceptable.

A second and simpler technique is illustrated in U.S. Patent No. 3,470,044 to Radimer. In this technique, the spent aqueous ammonium persulfate etching solution is used as the anolyte or an electrochemical cell. An electrolyte such as an acidic bisulfate or a bisulfate containing electrolyte is used as the catholyte of the cell. The cathode and anode sections of the cell are separated by a cathodic exchange membrane which permits the dissolved metal ions to pass from the anolyte into the catholyte but which prevents any substantial amount of persulfate in the anolyte from mixing with the catholyte. By passing an electric current through the catholyte and the anolyte, dissolved metal is removed from the solution at the cathode and sulfate values are converted to persulfate values at the anode.

While simpler, this second technique is believed to be inefficient and commercially unacceptable. The production of temperature sensitive, oxidizing cleaning solutions such as persulfate etchants often require electrolyte temperatures to be maintained within certain critical limits during processing. Therefore, an electrochemical cell for regenerating such a temperature sensitive solution should have some means for controlling electrolyte temperature. Furthermore, special anodes are often required to improve cell efficiency. Such temperature control means and special anodes are known in the art. U.S.S.R. Patent Nos. 311,502 and 470,307 both to Markov et al. illustrate some special anode constructions.

In accordance with the present invention, a relatively simple but yet highly efficient process for cleaning copper base materials is provided. The copper base material is cleaned by immersion in an

aqueous peroxydisulfuric acid solution containing peroxydisulfuric acid in a concentration in the range of about 1N to about 5N, preferably from about 1.5N to about 2.5N. The cleaning of the copper base material is carried out with the solution having a temperature in the range of about 15°C to about 30°C, preferably from about 20°C to about 25°C.

As the amount of copper dissolved in the cleaning solution increases and/or the amount of peroxydisulfuric acid becomes substantially depleted, the etching rate or cleaning power of the solution decreases. When the cleaning power or etching rate of the solution reaches a level where it is no longer feasible to clean the copper base material within commercial time constraints, the solution is withdrawn from the cell and replaced by a fresh cleaning solution. Thereafter, the withdrawn spent cleaning solution is recirculated to an electrolytic cell for regeneration.

In accordance with the present invention, the spent cleaning solution is introduced into the anode chamber of the electrolytic cell for use as an anolyte. An aqueous sulfuric acid solution containing from about 10% to about 50%, preferably about 15% to about 25%, by volume sulfuric acid is introduced into each cathode chamber of the cell as a catholyte. The anode chamber is preferably separated from each cathode chamber by a membrane-type structure. By applying an electric current across the cell, copper from the spent or depleted cleaning solution is plated out at the cathode and sulfate ions are oxidized to persulfate ions at the anode.

It has been found that overall efficiency of the cell can be increased by making a halide addition to the anolyte. Depending upon the halide used, the addition would be in the range of about 10 ppm to about 500 ppm. For example, the halide addition may be either from about 100 ppm to about 200 ppm of a chloride such as hydrochloric acid or from about 50 ppm to about 100 ppm of a fluoride such as hydrofluoric acid. As well as increasing cell efficiency, the halide addition has been found to decrease the rate of decomposition of the regenerated persulfate acid solution without significantly decreasing its cleaning power.

The apparatus described herein in connection with the accompanying drawings provides a means for practicing the process of the present invention.

Figure 1 is a schematic representation of a system for cleaning metal strip and regenerating the cleaning solution.

Figure 2 is a cross-sectional view in partial cross section of an electrochemical cell for regenerating the spent cleaning solution.

Figure 3 is a graph illustrating the etching rate of peroxydisulfuric acid as a function of its composition.

Figure 4 is a graph illustrating the stability of peroxydisulfuric acid as a function of time and temperature.

Figure 5 is a graph illustrating the stability of peroxydisulfuric acid with a halide addition as a function of time.

Figure 6 is a graph illustrating the effect of temperature on cell efficiency and peroxydisulfuric acid generation.

Figure 7 is a graph illustrating the effect of current density of generation of peroxydisulfuric acid using the cell of Figure 2.

The present invention is concerned with effectively cleaning or etching copper base materials including copper and copper alloys. The copper base materials to be cleaned may have any form. For example, the materials may be in strip form, tube form, rod form, wire form or shaped into an article. Furthermore, the cleaning may be carried out either batchwise or continuously. For the purpose of illustrating the present invention, reference will be made to cleaning copper or copper alloy strip in a continuous fashion.

Referring now to Figure 1, a system for cleaning the copper or copper alloy strip is illustrated. Since it is no longer economically justifiable to immediately discard and replace spent cleaning solutions, the cleaning system of Figure 1 includes an electrochemical cell 14 for regenerating the depleted cleaning solution. The copper or copper alloy strip not shown to be cleaned is passed through the cleaning tank 10 containing a cleaning solution in accordance with the present invention. The strip may be passed through the tank 10 in any suitable manner known in the art. If necessary, the strip to be cleaned may be subjected to a mechanical cleaning action such as abrasion or another pretreatment, e.g. being passed through a boiling caustic solution prior to entering the tank 10. The type of pretreatment used will of course depend upon the material being cleaned and the nature of the contaminants being removed.

In accordance with the present invention, the cleaning solution in the tank 10 comprises an aqueous peroxydisulfuric acid solution containing peroxydisulfuric acid in a concentration of from about 1N to about 5N. Peroxydisulfuric acid in such concentrations has been found to be an effective cleaning agent. While similar cleaning effectiveness has been obtained using persulfate salt cleaning solutions such as aqueous sodium persulfate or ammonium persulfate solutions, it is preferred in accordance with this invention to use a peroxyacid solution rather than a persulfate salt solution for the following reasons. The presence of additional ions such as $Na^+$ or $NH_4^+$ ions in a persulfate salt solution can lead to the production of undesirable products, e.g. ammonia. Furthermore, they complicate the regeneration process since the additional ions, i.e. $Na^+$ or $NH_4^+$ as well as the useful persulfate ions have to be replenished. In a preferred embodiment of the cleaning solution of the present invention, peroxydisulfuric acid is present in a concentration of about 1.5N to about 2.5N.

Since peroxydisulfuric acid tends to decompose more rapidly at elevated temperatures, it has been found to be particularly advantageous to carry out cleaning at a solution temperature in the range of about 15°C to about 30°C, preferably from about 20°C to about 25°C. If needed, the tank 10 may be provided with a suitable cooling system not shown to remove heat and maintain the cleaning solution within the desired temperature ranges.

An aqueous peroxydisulfuric acid solution tends to decompose sequentially as follows:

$$H_2S_2O_8+H_2O \rightarrow H_2SO_5+H_2SO_4 \quad (1)$$

$$H_2SO_5+H_2O \rightarrow H_2O_2+H_2SO_4 \quad (2)$$

$$2H_2O_2 \rightarrow 2H_2O+O_2 \quad (3)$$

It has been surprisingly found that as the peroxydisulfuric acid $H_2S_2O_8$ decomposes to a combination of peroxydisulfuric acid $H_2S_2O_8$+peroxymonosulfuric acid $H_2SO_5$ that the etching rate of the cleaning solution tends to increase. Thereafter, the etching rate remains substantially constant until $H_2S_2O_8$ changes almost completely.

As the copper or copper alloy strip passes through the cleaning solution, copper ions will dissolve into the solution and the following reactions typically take place:

$$H_2S_2O_8+Cu \rightarrow Cu^{2+}+H_2SO_4+SO_4^{=} \quad (4)$$

$$H_2SO_5+Cu \rightarrow CuSO_4+H_2O \quad (5)$$

$$H_2O_2+H_2SO_4+Cu \rightarrow CuSO_4+2H_2O \quad (6)$$

As a result, the depleted cleaning solution tends to contain some $H_2S_2O_8$, $H_2SO_5$, $H_2O_2$, $H_2SO_4$ and $Cu^{2+}$.

If too much copper is present in the depleted solution, $CuSO_4$ crystals could form. To prevent this from happening, it is desirable to withdraw the depleted solution before any significant copper ion level is reached. To this end, the tank 10 may be provided with means not shown for monitoring the bath condition. The monitoring means may comprise any suitable detection means known in the art to monitor any desired parameter such as bath temperature and/or copper concentration.

The cleaning tank 10 may also be provided with means not shown for agitating the cleaning solution to insure that fresh cleaning species contact the copper or copper alloy strip at all times. The agitating means may comprise any suitable stirring device known in the art such as one or more impellers not shown driven by a power source not shown.

After the cleaning power of the solution has been depleted so that cleaning cannot be carried out within a commercially acceptable time, the spent peroxydisulfuric acid solution is withdrawn from the tank 10 to the regeneration cell 14 via flow line 16 and valve 18. In a preferred embodiment of the present invention, the spent solution is introduced into the cell 14 as an anolyte.

Referring now to Figure 2, the regeneration cell 14 preferably has a central anode chamber 12 containing an anode 48 and a pair of cathode chambers 20, each containing a cathode 50. A physical separator 22 separates the anode chamber 12 from each cathode chamber 20. The physical separators 22 are primarily used to substantially prevent mixing of the products in the anode and cathode chambers and may be mounted in the cell 14 in any suitable manner. The physical separators 22 may either be a diaphragm such as a microporous polyethylene diaphragm or an ion exchange membrane such as a cation exchange membrane, e.g. a Nafion® membrane. A diaphragm would be used where it is desired to have a restricted bulk flow from one chamber to another without any preference to the charge of the ions passing therethrough. An ion exchange membrane would be used where it is desired to substantially prevent any bulk flow while permitting only the flow of certain preferred ions across the membrane.

The anode 48 is the most complex structure in the cell 14 because of the variety of roles that it plays during cell operation. At a bare minimum, the anode 48 comprises at least one hollow tube 34 or conduit through which, for reasons to be explained hereinafter, a heat exchange medium flows, at least one current collector 52 bonded to each tube 34 and at least one electrochemically active portion 54 bonded to each tube 34. In a preferred construction, the anode 48 comprises a grid-like structure formed by a plurality of spaced-apart substantially parallel tubes 34, a plurality of spaced-apart substantially parallel current collectors 52 arranged substantially transverse to the tubes 34, and a plurality of electrochemically active portions 54 located on each tube 34 substantially adjacent to and between the location where each current collector 52 is bonded to each tube 34.

Each of the tubes 34 is formed from an electrically conductive material 34. While any suitable electrically conductive material may be used, it has been found to be desirable to form the tubes 34 from titanium or a titanium alloy.

The current collectors 52 preferably each comprise a pair of spaced-apart strips of electrically conductive material. Each strip may be contoured to form good electrical contact with each tube 34. The strips may be bonded to the tubes 34 in any suitable manner known in the art, e.g. spot welding. To

promote a substantially uniform current distribution throughout the cell, the current collectors 52 are substantially uniformly distributed over the length of each tube 34. The number, the spacing and the size of the current collectors 52 depend upon the range of current densities used in the cell and the operating electrode surface area. While any suitable metal or metal alloy having good electrical conductivity properties may be used to form the current collectors 52, titanium or one of its alloys is a preferred material.

The electrochemically active portions 54 are preferably formed by metal members bonded to the tubes 34. For example, a plurality of metal rings can be spot welded to or inlayed in the tubes 34. The extent of the portions 54 and their surface area depend upon the range of current densities used during cell operation. If needed, the portions 54 could cover the total electrically conductive area exposed to the anolyte. While the portions 54 may be formed from any suitable metal or metal alloy, it is preferred to form them from platinum or one of its alloys because platinum forms oxides which slow down oxygen evolution at the anode 48. In a most preferred construction, the portions 54 are formed from bright, recrystallized platinum.

The cathode 50 in each cathode chamber 20 may be formed from a metallic mesh type structure such as a brass screen. It is desirable that the mesh structure have at least about 50% of its surface area open to promote good mass transport from the surrounding catholyte and better usage of the physical separators 22. Preferably, each cathode has about 50% to about 70% of its surface area open.

The removal of copper deposited on the cathode may be done in either a batchwise or a continuous manner. If done in a batchwise manner, the entire cathode structure may be removed and replaced. If done continuously, the cathode 50 may be formed from an endless metallic mesh belt not shown rotated by a suitable drive motor not shown. A metal removing device not shown such as a conventional scraping knife or blade may be used to remove the plated metal from the belt.

The anode 48 and the cathodes 50 may be electrically connected to any conventional power supply not shown known in the art. Preferably, the anode 48 is connected to the current source or power supply via one or more copper busses not shown attached to the current collectors 52.

The process of the present invention replenishes the persulfate values in the spent solution by electrochemically oxidizing sulfate ions to persulfate ions. To accomplish this, an aqueous sulfuric acid solution is introduced into the cell 14 as the catholyte. The aqueous sulfuric acid solution may be supplied to and circulated through each cathode chamber 20 by a circulation loop 24. The circulation loop 24 may have a pump 26 to circulate the catholyte as desired. Circulating the catholyte is desirable to help the efficiency of the system, particularly its cooling efficiency. In a preferred manner of using the cell 14, the catholyte flows through the chambers 20 in the same direction that the anolyte flows through the anode chamber 12.

It has been found that to generate the needed concentration of peroxydisulfuric acid for the cleaning solution, the catholyte should contain from about 10% to about 50% by volume sulfuric acid. Preferably, the aqueous sulfuric acid solution catholyte contains from about 15% to about 25% by volume sulfuric acid. It has been found that such concentrations assist in reducing the activity of water and, therefore, the evolution of oxygen at the anode.

Since the persulfate ion is relatively unstable in solution and its concentration tends to decay rapidly in time, it is desirable to maintain the catholyte and anolyte within a temperature range of about 0°C to about 20°C during the regeneration process. Preferably, the catholyte and anolyte are maintained at a temperature in the range of about 0°C to about 10°C. Control of heat build-up in the anolyte also helps to favor the production of persulfate values as opposed to the production of peroxide values.

To maintain the temperature of the anolyte and the catholyte within the desired limits, a heat exchange medium is circulated through the anode chamber 12. The heat exchange medium may comprise any suitable heat exchange fluid known in the art such as a refrigerated aqueous glycol solution. The heat exchange fluid may be circulated through the chamber 12 by heat exchange loop 28. Heat exchange loop 28 generally comprises a pump 30 for circulating the heat exchange fluid, a unit 32 for cooling and/or heating the heat exchange fluid, and the hollow tube or tubes 34 forming part of the anode 48 in the chamber 12. The heat exchange fluid preferably flows through the heat exchange loop 28 so that the fluid in each tube 34 travels in a direction counter to the flow direction of the electrolyte in the chamber 12.

To further assist in maintaining cell temperature within the desired limits, the circulation loop 24 may also have means not shown for cooling and/or heating the catholyte prior to its entry into chambers 20.

It also has been found that the rate of decomposition of the persulfate values may be decreased without significantly affecting the cleaning power of the regenerated solution by making a halide addition to the anolyte. The halide addition has also been found to increase overall cell efficiency. Generally, about 10 ppm to about 500 ppm of a suitable halide such as a chloride or a fluoride is added to the anolyte. If a chloride is being added, the addition should preferably be in the range of about 100 ppm to about 200 ppm. If a fluoride is being added, the addition should preferably be in the range of about 50 ppm to about 100 ppm. While the addition may be made using any form of the halide, it is preferred to make an acid addition such as hydrochloric acid or hydrofluoric acid.

In operation, a voltage sufficient to cause a current density in the range of about 0.4 $A/cm^2$ to about 1.0 $A/cm^2$, preferably from about 0.6 $A/cm^2$ to about 0.8 $A/cm^2$, is applied to the cell. A voltage in the range of about 4 to about 6 volts is generally sufficient to produce the desired current densities. Upon application of the voltage, the copper ions are taken out of solution and plated onto the cathodes 50 while sulfate ions are

oxidized to persulfate ions at the anode. There also tends to be some production of hydrogen gas at the cathode and oxygen gas at the anode; however, the production of these gases does not hamper the regeneration process. In fact, they create a bubble lifting effect that promotes both anolyte and catholyte movement.

After the cleaning solution has been regenerated, it may be returned to the cleaning tank 10 through the flow line 40. A valve 42 is provided in flow line 40 to permit recirculation of the solution to the anode chamber 12 via the flow line 44 if desired or if needed. To facilitate circulation of the cleaning solution, a pump 46 may be incorporated into the flow line 40. If desired, a storage tank not shown for holding the regenerated cleaning solution until it is needed may also be incorporated into the flow line 40.

If adjustments in raw material concentration, solution temperature or other parameters are needed prior to solution regeneration, the spent solution may be transferred from the cleaning tank 10 to a reconditioning unit 38. To do this, the spent solution is withdrawn from the tank 10 via line 17 and valve 36 in lieu of line 16 and valve 18. The reconditioning unit 38 may comprise any suitable solution reconditioning means known in the art. Of course, the type of reconditioning unit utilized will depend upon the type of adjustment that needs to be made to the spent solution. For example, reconditioning unit 38 may comprise means for cooling the spent solution or means for adding one or more raw materials to the spent solution. After the spent solution has been reconditioned, it may be transferred to the chamber 12 via the flow line 16.

The following examples are presented to demonstrate the present invention.

Example I

To measure their cleaning power or etching rate, the following cleaning solutions were prepared: (1) an aqueous peroxydisulfuric acid solution (PDA) containing 1.85M peroxydisulfuric acid and 200 ppm $Cl^-$ maintained at 25°C; (2) a 12% $H_2SO_4$—3% $H_2O_2$-distilled water solution maintained at 43°C; (3) a 12% $H_2SO_4$—3% $H_2O_2$-tap water solution maintained at 43°C; (4) an aqueous 2N ferric sulfate solution maintained at 80°C; and (5) an aqueous 2N ferric sulfate solution containing 0.3M $Cu^{2+}$ maintained at 80°C. The chloride addition to the peroxydisulfuric acid solution was made using HCl. 2.54×5.08 cm (1″×2″) coupons of copper alloy C11000 were prepared and weighed. Several coupons were then immersed in each solution for 15 seconds. After being removed, the coupons were rinsed in water and reweighed. The procedure was then repeated again with each coupon being reweighed a second time. The etching rate of each solution is reported in Table I.

TABLE I

| Solution | Etching rate (mg/cm²/sec) |
|---|---|
| 1.85M peroxydisulfuric acid w/200 ppm $Cl^-$ | .081 |
| 12% $H_2SO_4$—3% $H_2O_2$-distilled $H_2O$ | .070 |
| 12% $H_2SO_4$—3% $H_2O_2$-tap $H_2O$ | .011 |
| 2N ferric sulfate | .120 |
| 2N ferric sulfate+0.3M $Cu^{2+}$ | .095 |

Example II

A 1.6M peroxydisulfuric acid solution $H_2S_2O_8$ was prepared and permitted to decompose at room temperature (22°C) to peroxymonosulfuric acid $H_2SO_5$. At various intervals, the solution was tested to measure its composition, in particular, the concentration of peroxydisulfuric acid and peroxymonosulfuric acid. During these intervals, coupons of alloy C11000 were immersed in the solution as in Example I. Prior to the first immersion and after each immersion, the coupons were weighed so that the solution's etching rate could be determined. As can be seen from Figure 3, the etching rate increased as the $H_2S_2O_8$ decomposed into $H_2SO_5$ until a point after the solution had a concentration of about 1.2M $H_2SO_5$ and about 0.4M $H_2S_2O_8$. Thereafter, the etching rate was slightly decreased. Figure 3 also illustrates the etching rate of the 1.6M peroxydisulfuric acid as it decomposes compared to the etching rate of other cleaning solutions.

Example III

2.54×5.08 cm (1″×2″) coupons of copper alloys C68800 and C65400 were prepared. The C68800 coupons were prepared from C68800 strip that had been bell annealed. The C65400 coupons were prepared from C65400 strip material that had been strip annealed.

The C68800 samples were first immersed in a boiling caustic solution containing 1N NaOH. The solution was at about 100°C. Different coupon samples were immersed for different time intervals. The time intervals were 10 seconds, 20 seconds and 30 seconds. After being rinsed, some of the samples were immersed in an aqueous 12% $H_2SO_4$—3% $H_2O_2$ solution which was at about 43°C. The remainder of the

coupons were immersed in an aqueous peroxydisulfuric acid solution containing 1.8M peroxydisulfuric acid and about 200 ppm $Cl^-$ which was at about 25°C. The chloride addition to the peroxydisulfuric acid solution was made using HCl. The immersion time of the respective samples in each cleaning solution reflected its immersion time in the boiling caustic solution. For example, if the sample had been immersed in the caustic solution for 10 seconds, it was immersed in the acid cleaning solution for 10 seconds.

The C65400 samples were divided into two groups. The first group was immersed in an aqueous 12% $H_2SO_4$—3% $H_2O_2$ solution at about 43°C for the following time intervals: 20 seconds, 30 seconds; and 40 seconds. The second group was immersed in an aqueous peroxydisulfuric acid solution containing 1.8M peroxydisulfuric acid and about 100 ppm $F^-$ at about 25°C. The fluoride addition was made as HF. The C65400 samples were immersed in the peroxydisulfuric acid solution for the following time intervals: 15 seconds; 25 seconds; and 35 seconds. None of the C65400 samples were subjected to a caustic solution pretreatment.

All of the samples were rinsed in water and dried after immersion in the acid cleaning solution. The samples were then evaluated by dip soldering in a 60% Sn—40% Pb solder bath at about 238°C. A resin flux was applied prior to the dip tests. All samples were immersed in the bath for five seconds and then slowly pulled out. The solderability of the dipped samples was subjectively rated using the following system:

| Class | Description |
|---|---|
| 1 | Uniform smooth coating |
| 2 | Uniform rough coating |
| 2a | <5% dewetting |
| 3 | <50% dewetting<br><10% pinholes |
| 4 | >50% dewetting<br>>10% pinholes |
| 5 | No adhesion |

As can be seen from Table II, the samples of C68800 and C65400 cleaned with the peroxydisulfuric acid solution exhibited better solderability ratings—the lower the class, the better the rating. With respect to the C65400 samples, those cleaned in the peroxydisulfuric acid solution exhibited better solderability ratings with shorter immersion times.

TABLE II

| Alloy | Treatment | Immersion time (sec) | Solderability rating |
|---|---|---|---|
| C68800 | NaOH/$H_2SO_4$—$H_2O_2$ | 10 | 4 |
| C68800 | NaOH/$H_2SO_4$—$H_2O_2$ | 20 | 3—4 |
| C68800 | NaOH/$H_2SO_4$—$H_2O_2$ | 30 | 3—4 |
| C68800 | NaOH/$H_2S_2O_8$ w/200 ppm $Cl^-$ | 10 | 2 |
| C68800 | NaOH/$H_2S_2O_8$ w/200 ppm $Cl^-$ | 20 | 2 |
| C68800 | NaOH/$H_2S_2O_8$ w/200 ppm $Cl^-$ | 30 | 2 |
| C65400 | $H_2SO_4$—$H_2O_2$ | 20 | 4—5 |
| C65400 | $H_2SO_4$—$H_2O_2$ | 30 | 3—4 |
| C65400 | $H_2SO_4$—$H_2O_2$ | 40 | 2a |
| C65400 | $H_2S_2O_8$ w/100 ppm $F^-$ | 15 | 3 |
| C65400 | $H_2S_2O_8$ w/100 ppm $F^-$ | 25 | 2 |
| C65400 | $H_2S_2O_8$ w/100 ppm $F^-$ | 35 | 2 |

Example IV

To demonstrate the effect of temperature on the stability of peroxydisulfuric acid solutions, solutions initially containing 1.5M $H_2S_2O_8$ and about 2.5M $H_2S_2O_8$ were prepared. None of these solutions contained a halide addition. A portion of the 2.5M $H_2S_2O_8$ solution was kept at 0°C and allowed to decompose for several days. The 1.5M $H_2S_2O_8$ solution and the remainder of the 2.5M $H_2S_2O_8$ solution were kept at room temperature (about 22°C) and allowed to decompose for several days.

As can be seen from Figure 4, the solution at 0°C retained a substantially constant total molarity. As used herein, the total molarity is the sum of the peroxydisulfuric acid molarity and the peroxymonosulfuric acid molarity. In comparison, the total molarity of the solutions at room temperature deteriorated rather rapidly.

Example V

To illustrate the effect of a halide addition on decreasing the decomposition rate of peroxydisulfuric acid, an aqueous 1.6M $H_2S_2O_8$ solution was prepared. 100 ppm of $F^-$ was added to the solution using hydrofluoric acid. The solution with the halide addition was kept at room temperature and permitted to decompose.

As can be seen from Figure 5, the amount of $H_2S_2O_8$ in the solution decreased rather rapidly while the amount of $H_2SO_5$ in the solution increased. As a result, the total molarity, the sum of $H_2S_2O_8$ and $H_2SO_5$ in solution, remained substantially constant. It can be seen from Figure 5 that when the concentration of $H_2SO_5$ starts to decrease, the concentration of $H_2O_2$ increases. This clearly demonstrates the decomposition mechanism of peroxyacids discussed hereinbefore.

By comparing the total molarity curve of Figure 5 with the total molarity curve of the 1.5M solution in Figure 4, it can be seen that the addition of a halide to the peroxydisulfuric acid solution decreases its rate of decomposition as represented by total molarity.

Example VI

To illustrate the effect of a halide ion addition on the generation of peroxydisulfuric acid in an electrochemical cell such as the one shown in Figure 2, several aqueous 20 v/o $H_2SO_4$ solutions were prepared. The following additions were made to various samples of the $H_2SO_4$ solution: (a) 100 ppm $Cl^-$; (b) 200 ppm $Cl^-$; and (c) 100 ppm $F^-$. The chloride additions were made as hydrochloric acid and the fluoride addition was made as hydrofluoric acid.

The solutions with the halide additions were used as the anolyte in the cell. For comparison purposes, an aqueous 20 v/o $H_2SO_4$ solution without any halide addition was also used as an anolyte in the cell. For all tests, the catholyte was an aqueous 20 v/o $H_2SO_4$ solution. The anode and cathode chambers of the cell were separated by a Nafion membrane and an aqueous glycol solution at about 0°C was circulated through the anode chamber during each test. During the peroxydisulfuric acid generation process, the anolyte was maintained at a temperature in the range of 5°C to 8°C. A current density of 0.4 A/cm$^2$ at a voltage of 5.5V was applied to the cell.

As can be seen from Table III, the halide addition to the anolyte tended to improve cell efficiency. As used herein, cell efficiency may be defined as the amount of charge theoretically needed to convert 100% of the sulfuric acid to $H_2S_2O_8$ divided by the actual charge used to generate the peroxydisulfuric acid.

TABLE III

| Halide addition (ppm) | Peroxydisulfuric acid (molarity) | Cell efficiency (%) |
|---|---|---|
| None | 1.6 | 11 |
| 100 $Cl^-$ | 1.6 | 22 |
| 200 $Cl^-$ | 1.8 | 37 |
| 100 $F^-$ | 1.8 | 40 |

Example VII

To demonstrate the effect of temperature on cell efficiency and $H_2S_2O_8$ generation, an aqueous 20 v/o $H_2SO_4$ solution containing 100 ppm $F^-$ was prepared as in Example VI and introduced into the cell of Figure 2 as the anolyte. As before, an aqueous 20 v/o $H_2SO_4$ solution without any halide was used as the catholyte, Nafion membrane separated the anode and cathode chambers, and an aqueous glycol solution was circulated through the anode chamber. A current density of 0.6 A/cm$^2$ was applied across the cell.

As can be seen from Figure 6, cell efficiency decreased as anolyte temperature increased.

Furthermore, the rate of peroxydisulfuric acid production tended to be higher for the lower temperatures.

Example VIII

To demonstrate the effect of current density on cell efficiency and peroxydisulfuric acid generation, an aqueous sulfuric acid solution containing 100 ppm $F^-$ was prepared as in Example VI and introduced into the cell of Figure 2 as the anolyte. The other cell conditions were the same as in Example VII except that the anolyte temperature was maintained at 11°C and a current density of 0.4 A/cm² was applied during one test and a current density of 0.6 A/cm² was applied during a second test. It can be seen from Figure 7 that the higher the current density, the better the cell efficiency and the rate of production of peroxydisulfuric acid.

While a particular type of electrochemical cell has been illustrated to regenerate the peroxydisulfuric acid cleaning solution, other types of electrochemical cells could be utilized.

While any suitable heat exchange fluid at any desired temperature may be circulated through the anode chamber to control the temperature of the anolyte as needed, it is preferred to use an aqueous glycol solution at a temperature of about −5°C to about 5°C, most preferably at about 0°C, as the heat exchange fluid.

While the examples illustrate the use of peroxydisulfuric acid solutions to clean copper alloys C11000, C65400 and C68800, the solution may be used to clean copper and other copper alloys. Depending upon the type of copper or copper base alloy forming the material to be cleaned and the nature of the contaminants on the material, it may be desirable to pretreat the material prior to its immersion in the peroxydisulfuric acid solution. Any suitable pretreatment such as immersion in a boiling caustic solution or mechanical action may be used.

Preferably, the peroxydisulfuric acid cleaning solution of the present invention is a non-chromium containing solution that does not initially contain any significant amount of any other mineral acid.

**Claims**

1. A process for the cleaning or etching of the surface of copper and copper base alloys which comprises contacting the copper or copper base alloy with an aqueous oxidising acid solution, characterised in that the aqueous oxidising acid solution used is a chromium free aqueous solution of peroxydisulfuric acid having a peroxydisulfuric acid concentration of from about 1N to about 5N to effect the cleaning or etching of said surface by the dissolution of copper therefrom.

2. A process according to claim 1, characterised in that said peroxydisulfuric acid solution has a concentration of from 1.5N to 2.5N.

3. A process according to claim 1 or 2, characterised in that the copper or copper base alloy is contacted with said aqueous peroxydisulfuric acid solution at a temperature in the range 15—30°C.

4. A process according to claim 3, wherein said temperature is in the range 20—25°C.

5. A process according to any one of claims 1—4, characterised in that the spent etching solution is electrolytically regenerated and dissolved copper recovered by feeding the spent solution as an anolyte to the anode compartment of a compartmental electrolyte cell containing 10—50% by volume aqueous sulfuric acid as the catholyte in the cathode compartment, applying an electric current to said cell, and recovering from the cell cathodically deposited copper from the cathode compartment and regenerated etching solution from the anode compartment.

6. A process according to claim 5, characterised in that from 10 to 500 ppm of a water soluble halide are added to the spent electrolyte in the anode compartment of said cell.

7. A process according to claim 6, wherein said halide is hydrochloric acid added in an amount of 100 to 200 ppm, or hydrofluoric acid added in an amount of from 50 to 100 ppm.

8. A process according to claim 5, 6 or 7, characterised in that the temperature of the anolyte during the regeneration step is maintained in the range 0—20°C and the electric current is applied at a current density in the range 0.4 to 1 A/cm².

9. A process according to claim 8, wherein said temperature is in the range 0—10°C and said current density is in the range 0.6 to 0.8 A/cm².

10. A process according to claim 8 or 9, wherein the temperature of the anolyte is controlled by circulating a fluid cooling medium through the anode.

**Patentansprüche**

1. Verfahren zum Reinigen oder Ätzen der Oberfläche von Kupfer und Legierungen auf Kupferbasis durch Kontaktieren des Kupfers oder der Legierung auf Kupferbasis mit einer wässrigen oxidierenden Säurelösung, dadurch gekennzeichnet, daß die wässrige oxidierende Säurelösung eine chromfreie wässrige Lösung von Peroxodischwefelsäure ist mit einer Peroxodischwefelsäurekonzentration von etwa 1N bis etwa 5N, um die Reinigung oder das Ätzen der Oberfläche durch Herauslösen von Kupfer hieraus zu erzielen.

2. Verfahren nach Anspruch 1, dadurch gekennzeichnet, daß die Peroxodischwefelsäurelösung eine Konzentration von 1,5N bis 2,5N aufweist.

3. Verfahren nach einem der Ansprüche 1 oder 2, dadurch gekennzeichnet, daß das Kupfer oder die Legierung auf Kupferbasis mit der wässrigen Peroxodischwefelsäurelösung bei einer Temperatur im Bereich von 15 bis 30°C in Kontakt gebracht wird.

4. Verfahren nach Anspruch 3, dadurch gekennzeichnet, daß die Temperatur im Bereich von 20 bis 25°C liegt.

5. Verfahren nach einem der Ansprüche 1 bis 4, dadurch gekennzeichnet, daß die verbrauchte Ätzlösung elektrolytisch regeneriert wird und daß das aufgelöste Kupfer durch folgende Schritte wiedergewonnen wird: Zuführen der verbrauchten Lösung als Anolyt zu dem Anodenteil einer abgeteilten Elektrolytzelle, die im Kathodenteil 10 bis 50 Vol.% wässriger Schwefelsäure als Katholyt enthält, Anlegen eines elektrischen Stroms an die Zelle und Wiedergewinnen des kathodisch niedergeschlagenen Kupfers von dem Kathodenteil und der regenerierten Ätzlösung von dem Anodenteil der Zelle.

6. Verfahren nach Anspruch 5, dadurch gekennzeichnet, daß 10 bis 500 ppm eines wasserlöslichen Halogenids dem aufgebrauchten Elektrolyten in dem Anodenteil der Zelle zugegeben werden.

7. Verfahren nach Anspruch 6, dadurch gekennzeichnet, daß das Halogenid Chlorwasserstoffsäure, die in einer Menge von 100 bis 200 ppm zugegeben wird, oder Fluorwasserstoffsäure ist, die in einer Menge von 50 bis 100 ppm zugegeben wird.

8. Verfahren nach einem der Ansprüche 5, 6 oder 7, dadurch gekennzeichnet, daß die Temperatur des Anolyten während der Wiedergewinnung im bereich von 0 bis 20°C gehalten wird und daß der elektrische Strom mit einer Stromdichte im Bereich von 0,4 bis 1 A/cm$^2$ angelegt wird.

9. Verfahren nach Anspruch 8, dadurch gekennzeichnet, daß die Temperatur im Bereich von 0 bis 10°C liegt und daß die Stromdichte im Bereich von 0,6 bis 0,8 A/cm$^2$ liegt.

10. Verfahren nach einem der Ansprüche 8 oder 9, dadurch gekennzeichnet, daß die Temperatur des Anolyten durch Zirkulieren eines fluiden Kühlmediums durch die Anode gesteuert wird.

**Revendications**

1. Un procédé pour nettoyer ou décaper la surface du cuivre et des alliages à base de cuivre, qui consiste à mettre en contact le cuivre ou l'alliage à base de cuivre avec une solution aqueuse d'un acide oxydant, caractérisé en ce que la solution aqueuse d'un acide oxydant qu'on utilise pour le nettoyage ou le décapage de ladite surface par dissolution du cuivre de cette surface est une solution aqueuse d'acide peroxydisulfurique, à une concentration environ N à 5N en cet acide.

2. Un procédé selon la revendication 1, caractérisé en ce que la solution d'acide peroxydisulfurique est à une concentration 1,5N à 2,5N.

3. Un procédé selon la revendication 1 ou 2, caractérisé en ce que l'on met en contact le cuivre ou l'alliage à base de cuivre avec la solution aqueuse d'acide peroxydisulfurique, à une température dans l'intervalle de 15 à 30°C.

4. Un procédé selon la revendication 3, caractérisé en ce que la température se situe dans l'intervalle de 20 à 25°C.

5. Un procédé selon l'une quelconque des revendications 1 à 4, caractérisé en ce que la solution d'attaque usée est régénérée par électrolyse et le cuivre dissous est récupéré par envoi de la solution usée, en tant qu'anolyte, dans le compartiment anodique d'une cellule d'électrolyse compartimentée contenant en tant que catholyte dans le compartiment cathodique une solution aqueuse d'acide sulfurique à 16—50% en volume, récupération, dans le compartiment cathodique, du cuivre déposé sur la cathode de la cellule, et régénération de la solution d'attaque sortant du compartiment anodique.

6. Un procédé selon la revendication 5, caractérisé en ce que l'on ajoute à l'électrolyte usé, dans le compartiment anodique de la cellule, de 10 à 500 ppm d'un halogénure soluble dans l'eau.

7. Un procédé selon la revendication 6, caractérisé en ce que cet halogénure consiste en acide chlorhydrique ajouté en proportions de 100 à 200 ppm ou en acide fluorhydrique ajouté en proportions de 50 à 100 ppm.

8. Un procédé selon la revendication 5, 6 ou 7, caractérisé en ce que la température de l'anolyte au cours de l'opération de régénération est maintenue dans l'intervalle de 0 à 20°C et le courant électrique est appliqué à une densité de courant dans l'intervalle de 0,4 à 1 A/cm$^2$.

9. Un procédé selon la revendication 8, caractérisé en ce que la température se situe dans l'intervalle de 0 à 10°C et la densité de courant dans l'intervalle de 0,6 à 0,8 A/cm$^2$.

10. Un procédé selon la revendication 8 ou 9, caractérisé en ce que l'on règle la température de l'anolyte par circulation d'un liquide de refroidissement dans l'anode.

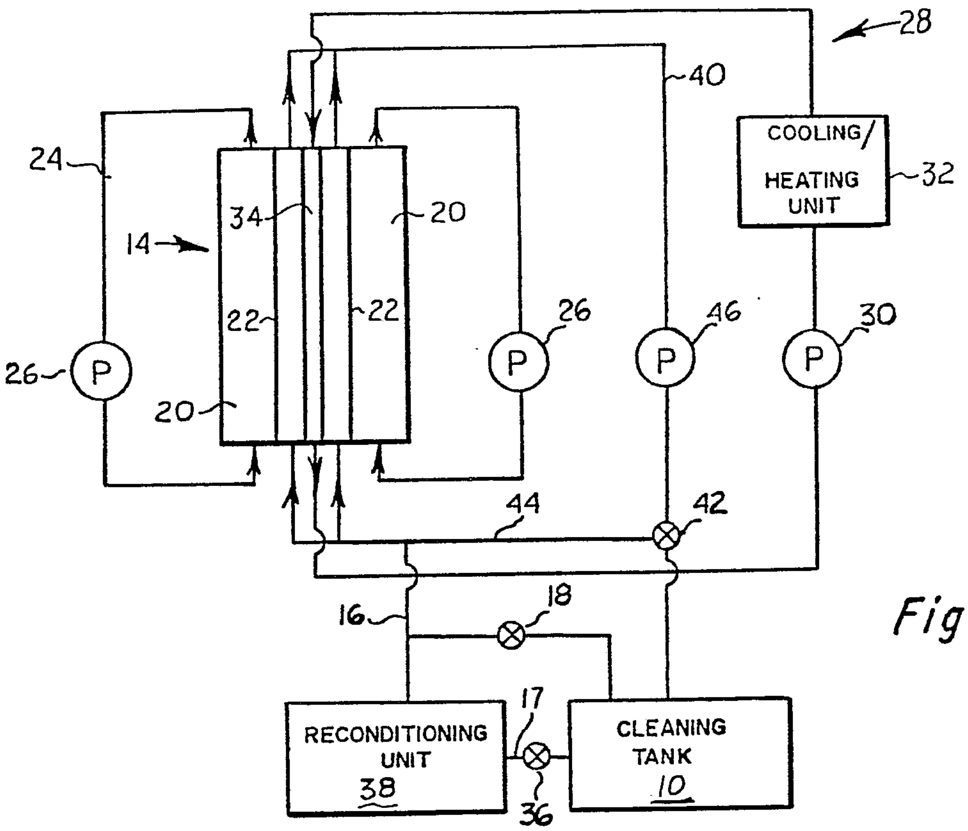
28
40
COOLING/
HEATING
UNIT
32
24
34
20
14
22
22
26
P
26
46
30
20
44
42
16
18
RECONDITIONING
UNIT
38
17
36
CLEANING
TANK
10

Fig-1

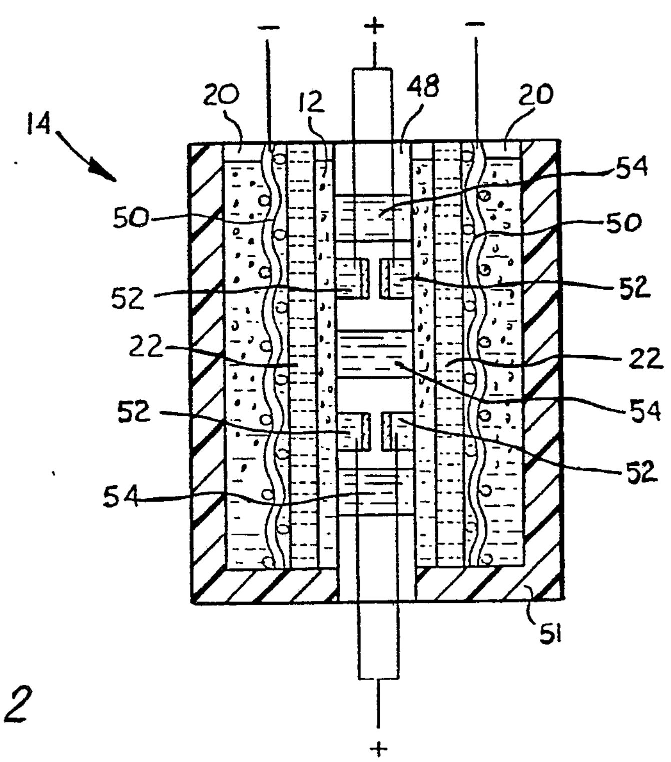
−
+
−
20
12
48
20
14
54
50
50
52
52
22
22
54
52
52
54
51
+

Fig-2

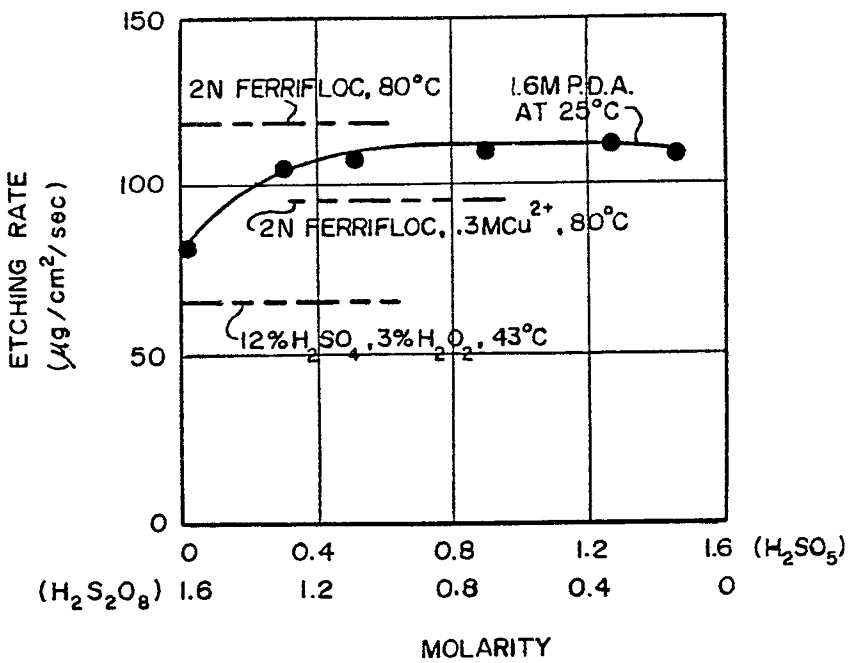
150
100
50
0
ETCHING RATE
($\mu g/cm^2/sec$)
2N FERRIFLOC, 80°C
1.6M P.D.A.
AT 25°C
2N FERRIFLOC, .3MCu$^{2+}$, 80°C
12% $H_2SO_4$, 3% $H_2O_2$, 43°C
0
0.4
0.8
1.2
1.6 ($H_2SO_5$)
($H_2S_2O_8$) 1.6
1.2
0.8
0.4
0
MOLARITY

*Fig-3*

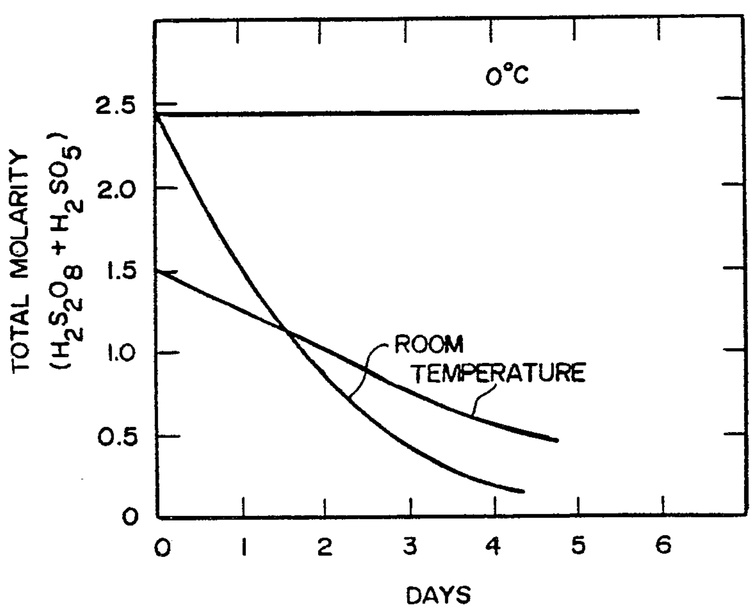
TOTAL MOLARITY
($H_2S_2O_8$ + $H_2SO_5$)
2.5
2.0
1.5
1.0
0.5
0
0°C
ROOM
TEMPERATURE
0
1
2
3
4
5
6
DAYS

*Fig-4*

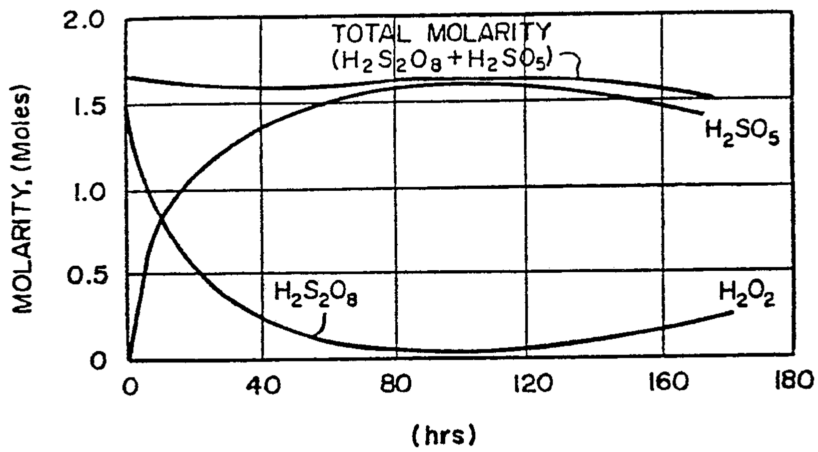


Fig-5

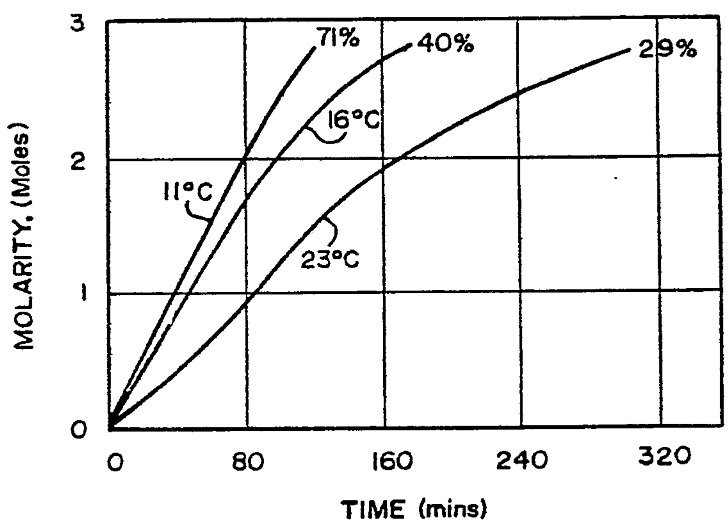


Fig-6

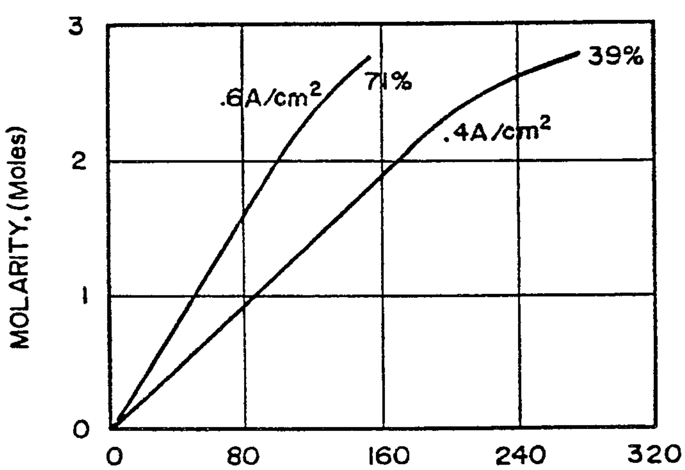


Fig-7

TIME (mins)